# EUROPEAN PATENT APPLICATION

(11) **EP 4 539 100 A1**
(43) Date of publication of application: **16.04.2025**
(21) Application number: 23203112.0
(22) Date of filing: 12.10.2023
(51) Int. Cl.: H01L 21/20

(54) **SEMICONDUCTOR WAFER HAVING A MULTILAYERED STRUCTURE AND METHOD FOR PRODUCING THE SAME**

(71) Applicant: Siltronic AG, 81677 München (DE)
(72) Inventor: Michler, Sondre, 84489 Burghausen (DE); Storck, Peter, 84489 Burghausen (DE); Thapa, Sarad Bahadur, 84489 Burghausen (DE)
(74) Representative: Grundner, Sebastian

(57) **Abstract**

A semiconductor wafer having a multilayered structure and a diameter of not less than 150 mm and not more than 300 mm, wherein the multilayered structure comprises in this order
a monocrystalline silicon substrate having a {111} orientation;
a low temperature AIN nucleation layer;
a high temperature AIN nucleation layer;
an Al_{z}Ga_{1-z}N layer;
islands of AlₓGa₁₋ₓN and islands of Al_{y}Ga_{1-y}N;
a superlattice structure comprising 20 to 60 periods, each period consisting of a layer of AlₓGa₁₋ₓN and a layer of Al_{y}Ga_{1-y}N; and
one or more monocrystalline, doped GaN layers having a total thickness of not less than 6 µm,
wherein at least one of the one or more monocrystalline, doped GaN layers has a threading dislocation density of not more than 5.0×10⁸ cm⁻², and
wherein 0.3≤z≤0.7; 0.7≤x≤1.0; and 0≤y≤0.5.

## Description

### Technical Field

The present invention is directed to a semiconductor wafer having a multilayered structure and a method for producing the same.

### Discussion of Closest Prior Art

In modern electronics, gallium nitride (GaN) power devices have attracted increased attention due to their superior high-voltage and high-current capacity. In particular, vertical GaN power devices are promising candidates for next generation high-voltage and high-current power switching applications in electric vehicles, smart grids and renewable energy processes.

For such device, a relatively thin layer of a heteroepitaxial GaN film is deposited on a silicon wafer, with a buffer layer in between. The deposition of a buffer layer is necessary because of the lattice mismatch and the mismatch between the coefficients of thermal expansion of Si and GaN.

Even in the presence of one or more buffer layers, the lattice mismatch results in a relatively high defect density in the GaN layer. Moreover, the different coefficients of thermal expansion can lead to cracks if the GaN layer exceeds a certain thickness. To account for the different coefficient of thermal expansion, sufficient compressive stress must be incorporated into a GaN layer during growth to counteract the tensile stress to which it is subjected during the cooling process. The relatively high defect density and the limited thickness of the GaN layer limits the performance of the power device, for example in terms of its breakdown voltage.

There is thus a need for improved GaN structures with new buffer layers that enable the fabrication of GaN drift layers with low defect density and a high thickness of more than 5 µm.

EP 2 727 133 B1 discloses a GaN structure with a buffer layer comprising two translation layers of the composition B_{w}AlₓGa_{y}In_{z}N. Thus, a GaN layer having a thickness of more than 5 µm and a relatively low dislocation density can be obtained.

Yet, the buffer layer is relatively thick and complex and the thickness of the GaN drift layer is limited.

Y. Zhang et al. J. Phys. D: Appl. Phys. 51 (2018) 273001 describe a buffer layer which enables the preparation of a GaN layer having a dislocation density of 2 × 10⁸ cm⁻² and a thickness of less than 6 µm.

A. Dadgar et al. Phys. Stat. Sol. (C) 0, No. 6 (2003) describe the reduction of dislocations by a superlattice structure having 15 periods. It is explained that dislocations are bent at the interfaces of the layers of the superlattice, thereby increasing the probability of recombination and annihilation with other dislocations with opposite burgers vector. The mechanism of annihilation of dislocations in such multilayered structures is also discussed by A. E. Romanov and J. S. Speck. Appl. Phys. Lett. 83.13 (2003): 2569-2571; by B. Daudin, B. et al. Phys. Rev. B 56.12 (1997): R7069; and by M. Imura et al. J. Cryst. Growth 300.1 (2007): 136-140.

### Objective and Solution Provided by the Invention

The present invention aims at providing a new GaN structure having a GaN drift layer with an increased thickness, reduced dislocation density and reduced stress in the GaN drift layer.

The above problem is solved by the semiconductor wafer having a multilayered structure according to the first aspect of the present invention.

In a second aspect, the present invention is directed to a method of producing a semiconductor wafer having a multilayered structure. This method is suitable for manufacturing the semiconductor wafer having a multilayered structure according to the first aspect of the present invention.

In particular, the inventors have found that specific process conditions can induce the growth of islands of AlₓGa₁₋ₓN and islands of Al_{y}Ga_{1-y}N, with 0.7≤x≤1.0 and 0≤y≤0.5, followed by a superlattice comprised of layers of these materials. It has been surprisingly found that the presence of islands reduces the dislocations in a comparatively small section of the buffer layer. These islands annihilate dislocations and reduce compressive stress relaxation during GaN growth. Thus, sufficiently high compressive stress is maintained, so that the tensile stress during cooling can be compensated. As a result, GaN drift layers with high thickness and low dislocation density can be obtained in a process that is susceptible for industrial application. In addition, as dislocations, in particular threading dislocations, can be efficiently reduced in a comparatively small section of the buffer layer, the thickness of the buffer layer as a whole can be reduced. This is advantageous as this allows to reduce production costs and enhances heat transport through the buffer layer during operation of the device.

The semiconductor wafer having a multilayered structure according to the first aspect of the present invention has a diameter of not less than 150 mm and not more than 300 mm. The multilayered structure of the wafer comprises in this order
a monocrystalline silicon substrate having a {111} orientation;
a low temperature AIN nucleation layer;
a high temperature AIN nucleation layer;
an Al_{z}Ga_{1-z}N layer;
islands of AlₓGa₁₋ₓN and islands of Al_{y}Ga_{1-y}N;
a superlattice structure comprising 20 to 60 periods, each period consisting of a layer of AlₓGa₁₋ₓN and a layer of Al_{y}Ga_{1-y}N; and
one or more monocrystalline, doped GaN layers having a total thickness of not less than 6 µm,
wherein at least one of the one or more monocrystalline, doped GaN layers has a threading dislocation density of not more than 5.0×10⁸ cm⁻², and
wherein 0.3≤z≤0.7; 0.7≤x≤1.0; and 0≤y≤0.5.

In a second aspect of the present invention, a method of producing a semiconductor wafer having a multilayered structure is provided. The method comprises the following steps in this order:
(i) providing a monocrystalline silicon substrate having a {111} orientation;
(ii) flowing a gas stream which comprises an aluminum precursor and no nitrogen precursor over the substrate at a temperature of not less than 700 °C and not more than 900 °C so that the total amount of aluminum flown over the substrate is not less than 0.1 µmol and not more than 250 µmol,
(iii) depositing a low temperature AlN nucleation layer by flowing a gas stream comprising an aluminum precursor and a nitrogen precursor over the substrate at a temperature of not less than 700 °C and not more than 900 °C,
(iv) depositing a high temperature AlN nucleation layer by flowing a gas stream comprising an aluminum precursor and a nitrogen precursor over the substrate at a temperature of not less than 950 °C and not more than 1100 °C,
(v) depositing an Al_{z}Ga_{1-z}N layer with 0.3≤z≤0.7 by flowing a gas stream comprising an aluminum precursor, a gallium precursor and a nitrogen precursor over the substrate at a temperature of not less than 950 °C and not more than 1050 °C,
(vi) depositing alternately AlₓGa₁₋ₓN with 0.7≤x≤1.0 and Al_{y}Ga_{1-y}N with 0≤y≤0.5 for 20 to 100 cycles by flowing a gas stream comprising an aluminum precursor, a gallium precursor and a nitrogen precursor over the substrate at a temperature of not less than 1000°C and not more than 1100°C, wherein the alternation of the deposition is achieved by changing the composition of the gas stream; and
(vii) depositing one or more monocrystalline, doped GaN layers by flowing a gas stream comprising a gallium precursor, a nitrogen precursor and a dopant precursor over the substrate at a temperature of not less than 900 and not more than 1200°C.

The method according to the second aspect of the present invention does not need ELOG techniques or in-situ masking with silicon nitride and is therefore more economical in terms of process time and costs. The method is therefore more susceptible to industrial application. Furthermore, the method according to the second aspect of the present invention allows to obtain specific shapes and dimensions of the islands formed in step (vi).

The growth of islands and a superlattice structure is an effective way to bend and annihilate dislocations, leading to a drastic reduction in dislocation density in a small section of the buffer. Thus, it is possible to avoid the use of time-consuming conventional methods such as ELOG and thick buffer structures to achieve similar dislocation densities. The method of the present invention allows the preparation of a superlattice structure, in which sufficient compressive stress is preserved in the crystal lattice. As a result, the positive amount of warp per unit thickness during the GaN growth on top of the superlattice structure is sufficiently high to compensate for the tensile stress generated upon cooling down. A positive warp within the meaning of the present invention indicates that the semiconductor wafer has a convex shape. A negative warp within the meaning of the present invention indicates that the semiconductor wafer has a concave shape.

Also, the lower dislocation densities result in a higher critical breakdown field, such that a lower GaN thickness is required to achieve the same breakdown voltage. This enables sufficiently thick GaN device layers to be grown to produce PIN diodes and transistors for medium-voltage applications (600-1700 V) with either a fully vertical or quasi-vertical configuration.

### Brief Description of Figures

**Fig. 1** shows a plan-view image of a semiconductor wafer recorded on a scanning electron microscope (SEM) after 5 cycles of depositing alternately AlₓGa₁₋ₓN with 0.7≤x≤1.0 and Al_{y}Ga_{1-y}N with 0≤y≤0.5 according to steps (i) to (vi) of the method of the present invention.
**Fig. 2a** shows the reverse current-voltage curves (I-V curves) at different temperatures of a PIN diode with drift layer having a thickness of 3 µm and produced according to the method of the present invention.
**Fig. 2b** shows the temperature-dependent breakdown voltage of a PIN diode with a drift layer having a thickness of 3 µm. The PIN diode was formed from a semiconductor wafer produced according to the method of the present invention and is the same PIN diode as studied in Fig. 2a.
**Fig. 3** shows the reverse I-V curves of two PIN diodes having a drift layer with a thickness of 3.5 µm and 4.5 µm, respectively. The reverse I-V curves were measured at room temperature. Both samples were prepared from a semiconductor wafer prepared according to the method of to the present invention.
**Fig 4a** is a schematic drawing of the multilayered structure of a PIN-stack of a semiconductor wafer according to the present invention.
**Fig. 4b** shows a cross-sectional image of a similar PIN-stack as shown in Fig. 4a recorded on a scanning electron microscope.
**Fig. 5** shows an image of the surface of a semiconductor wafer according to the present invention in plan-view recorded on an optical microscope.
**Fig. 6** is a cross-sectional TEM image of a semiconductor wafer according to the present invention and prepared according to the method of the present invention, showing that dislocations are bent and annihilated by the islands.

### Detailed Description of the Invention

In the following, the semiconductor wafer having a multilayered structure according to the first aspect of the present invention is disclosed. The multilayered structure of the wafer comprises in this order
a monocrystalline silicon substrate having a {111} orientation;
a low temperature AIN nucleation layer;
a high temperature AIN nucleation layer;
an Al_{z}Ga_{1-z}N layer;
islands of AlₓGa₁₋ₓN and islands of Al_{y}Ga_{1-y}N;
a superlattice structure comprising 20 to 60 periods, each period consisting of a layer of AlₓGa₁₋ₓN and a layer of Al_{y}Ga_{1-y}N; and
one or more monocrystalline, doped GaN layers having a total thickness of not less than 6 µm,
wherein at least one of the one or more monocrystalline, doped GaN layers has a threading dislocation density of not more than 5.0×10⁸ cm⁻², and
wherein 0.3≤z≤0.7; 0.7≤x≤1.0; and 0≤y≤0.5.

The monocrystalline silicon substrate has a {111} orientation. The substrate is preferably a monocrystalline silicon wafer having a diameter of not less than 150 mm and not more than 300 mm, preferably not less than 150 mm and not more than 210 mm. In a particularly preferred embodiment, the monocrystalline silicon substrate has a diameter of 150 mm or 200 mm. The monocrystalline silicon substrate has preferably a thickness of not less than 625 µm and not more than 1500 µm. The monocrystalline silicon substrate is optionally doped and may have a silicon oxide or silicon nitride protection layer on its backside.

A low temperature AlN nucleation layer within the meaning of the present invention is a layer of the composition AIN deposited by metalorganic chemical vapour deposition (MOCVD) at a temperature of not more than 900°C. The low temperature AlN nucleation layer is formed on top of the monocrystalline silicon substrate. It has preferably a thickness of not less than 1 nm and not more than 50 nm. The purpose of the low temperature AlN nucleation layer is to provide a high density of nucleation sites on the silicon substrate to promote the growth of a continuous high temperature AlN layer, avoiding large pits. The low temperature AlN nucleation layer is formed by flowing a gas stream comprising an aluminum precursor and a nitrogen precursor over the substrate at a temperature of not less than 700 °C and not more than 900 °C.

A high temperature AlN nucleation layer within the meaning of the present invention is a layer of the composition AIN deposited by metalorganic chemical vapour deposition (MOCVD) at a temperature of not less than 950°C. The high temperature AlN nucleation layer is formed on top of the low temperature AlN layer. It has preferably a thickness of not less than 50 nm and not more than 500 nm, more preferably of not less than 100 nm and not more than 300 nm. The high temperature AlN layer is deposited to protect the silicon substrate from meltback-etching that occurs when Ga is in contact with silicon at elevated temperatures. In the initial growth phase, islands form and coalesce. As a result of the high lattice mismatch between AIN and silicon and the subsequent island coalescence, the high temperature AlN nucleation layer has a high density of threading dislocations. The AIN layer grows under tensile stress, which leads to a concave warp of the wafer with increasing AlN thickness. The high temperature AlN nucleation layer is deposited at high temperature by flowing a gas stream comprising an aluminum precursor and a nitrogen precursor over the substrate with the low temperature AlN layer on top of it at a temperature of not less than 950 °C and not more than 1100 °C.

The Al_{z}Ga_{1-z}N layer is formed on top of the high temperature AlN nucleation layer and has an Al content defined by 0.3≤z≤0.7. More preferably, the Al_{z}Ga_{1-z}N layer has a composition defined by 0.4≤z≤0.6, most preferably 0.45≤z≤0.55. The Al_{z}Ga_{1-z}N layer has preferably a thickness of not less than 10 nm and not more than 400 nm, more preferably not less than 20 nm and not more than 200 nm, and most preferably not more than 100 nm. The effect of the Al_{z}Ga_{1-z}N layer is to smoothen the surface after AIN growth and to annihilate dislocations. Preferably, the Al_{z}Ga_{1-z}N layer is under compressive stress. If the Al_{z}Ga_{1-z}N layer is under compressive stress, a change of the curvature of the wafer is initiated, so that the multilayered structure is less concave as compared to its curvature after deposition of the AIN layers and before the Al_{z}Ga_{1-z}N deposition. The Al_{z}Ga_{1-z}N layer is deposited by flowing a gas stream comprising an aluminum precursor, a gallium precursor and a nitrogen precursor, and optionally a carrier gas such as hydrogen or nitrogen, over the substrate with the low and the high temperature AIN layers at a temperature of not less than 950 °C and not more than 1050 °C.

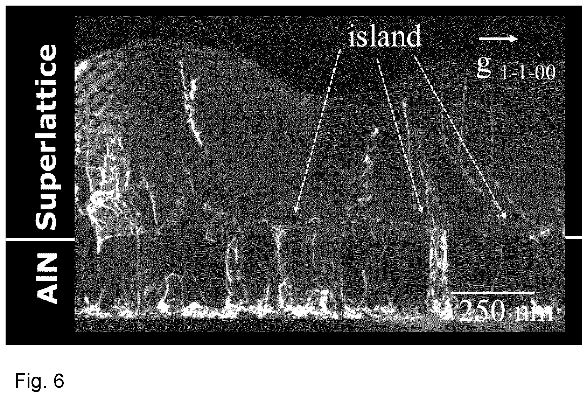

On top of the Al_{z}Ga_{1-z}N layer, islands of AlₓGa₁₋ₓN and islands of Al_{y}Ga_{1-y}N, with 0.7≤x≤1.0 and 0≤y≤0.5, preferably 0.80≤x≤1.00 and 0.05≤y≤0.4, most preferred 0.90≤x≤1.00 and 0.10≤y≤0.20, are formed. The total density of islands of AlₓGa₁₋ₓN and islands of Al_{y}Ga_{1-y}N is preferably not less than 1.0×10⁷ cm⁻² and not more than 1.0×10¹⁰ cm⁻², more preferably, not less than 5.0×10⁷ cm⁻² and not more than 5.0×10⁹ cm⁻². The total density of islands within the meaning of the present invention is determined from plan-view, *i.e*. when viewed from an axial direction. In other words, the island density refers to the density of islands in a plane parallel to the wafer surface and located between Al_{z}Ga_{1-z}N layer and the GaN layers. The island density is preferably determined after not less than 5 cycles, more preferably after not less than 10 and not more than 20 cycles, of depositing alternately AlₓGa₁₋ₓN with 0.7≤x≤1.0 and Al_{y}Ga_{1-y}N with 0≤y≤0.5. In other words, it is preferable to determine the island density close to the time of coalescence, before the formation of continuous layers of the super lattice structure is induced. The mechanism of island formation will be discussed in more detail below in the context of the method according to the second aspect of the present invention. Fig. 6 is a cross-sectional image of a semiconductor wafer according to the present invention and prepared according to the method of the present invention, showing that dislocations are bent and annihilated by the islands. The image was recorded on a transmission electron microscope.

If the island density is in the above range, the annihilation of dislocations is improved, resulting in a lower dislocation density in the subsequently deposited layers. More particularly, if the island density is lower than 1.0×10⁷ cm⁻², the distance between neighboring islands is too large for the islands to coalesce. Instead, the layer is closed by vertical growth between the islands. As a result, the areas between the islands have a high dislocation density. In addition, if the island density is lower than 1.0×10⁷ cm⁻², the thickness at the time of coalescence of adjacent islands is large. Since the islands grow with a low stress, tensile stress induced during cooling is not compensated. If the island density is above 1.0×10¹⁰ cm⁻², the annihilation of dislocations is not effective, either.

Preferably, the islands have a height of not less than 100 nm and not more than 1000 nm. The height is the maximum length of an island in a direction perpendicular to the surface of the wafer, *i.e.* in a direction perpendicular to a plane of the monocrystalline silicon substrate having a {111} orientation. The height refers to the height of the islands at the time of coalescence. If the height of the islands falls within the range of 100 to 1000 nm, the annihilation of dislocations is promoted and thermally induced stress is compensated. In the present invention, the height of the islands is also referred to as thickness of the islands. Preferably, the islands have an aspect ratio of not less than 0.1 and not more than 100, more preferably not less than 0.1 and not more than 10. The aspect ratio is the ratio of width to height of an island. The width is the maximum diameter of an island in a plane parallel to the wafer surface, *i.e.* the maximum width in a plane parallel to the {111} orientation of the monocrystalline silicon substrate. Thus, the maximum width is determined in plan-view of the wafer. The height and diameter of the islands and the island density can be determined by means of scanning electron microscopy (SEM). The aspect ratio within the meaning of the present invention is preferably a median aspect ratio, which is the median value of the aspect ratios of at least 100 islands.

If the aspect ratio is above 100, the height of the islands at the time of coalescence is low. As a result, dislocations will reach the upper surface without interacting with dislocations bent at adjacent islands, resulting in a high dislocation density in the doped or non-doped GaN layers of the semiconductor wafer. If the aspect ratio is below 0.1, the height of the islands is relatively high, so that the thermally induced stress is not compensated for during cooling.

Preferably, the islands have tilted side facets. The tilted side facets cause bending of dislocations and, thus, the annihilation of dislocations is further promoted. More particularly, the dislocations, in particular threading dislocations, are bent at the facets of the islands and concentrate at the island boundaries, thereby increasing the probability of annihilation of these dislocations.

After 5 to 20 periods of depositing alternately AlₓGa₁₋ₓN and Al_{y}Ga_{1-y}N, coalescence takes place and, thus, the deposition of continuous layers is initiated on top of the islands.

When the deposition of continuous layers is initiated, a superlattice structure is formed. A superlattice is a periodic structure of layers of two or more materials, wherein the thickness of one period is in the nanometer range. In the present invention, the term superlattice structure refers to a periodic structure of two materials, wherein each period has a thickness in the nanometer range and contains two continuous layers. The term continuous layer within the meaning of the present invention refers to a uniform layer covering more than 90%, preferably more than 95%, and most preferably more than 98% of the underlying surface of the semiconductor wafer on which it is deposited.

The layers in the periodic structure are preferably continuous layers. In the present invention, the superlattice structure comprises 20 to 60 periods, wherein each period consists of a, preferably continuous, layer of AlₓGa₁₋ₓN and a, preferably continuous, layer of Al_{y}Ga_{1-y}N, with 0.7≤x≤1.0 and 0.0≤y≤0.5, preferably 0.80≤x≤1.00 and 0.05≤y≤0.40, most preferred 0.90≤x≤1.00 and 0.10≤y≤0.20. In a preferred embodiment, the superlattice structure comprises 20 to 40 periods. Preferably, each period of the superlattice structure has a thickness of not less than 18 nm and not more 50 nm. More preferably, in each period of the super lattice structure, the layer of AlₓGa₁₋ₓN has preferably a thickness of not less than 3 nm and not more than 15 nm and the layer of A_{y}Ga_{1-y}N has preferably a thickness of not less than 15 nm and not more than 35 nm. The average Al content of the superlattice structure is preferably less than 50 wt.%. Dislocations are also bent at the interfaces between each layer of AlₓGa₁₋ₓN and each layer of Al_{y}Ga_{1-y}N, due to the strain field, which also results in a higher probability of annihilation. Thus, the superlattice structure promotes the annihilation of dislocations, so that monocrystalline, doped or non-doped GaN layers with a lower dislocation density can be deposited on top of the superlattice structure. The desired degree of annihilation of dislocation is achieved when the superlattice structure contains 20 to 60 periods of continuous layers, preferably 20 to 40 periods of continuous layers.

In a preferred embodiment, the total thickness of the layers located between the monocrystalline silicon substrate and the one or more monocrystalline, doped GaN layers is not less than 0.7 µm and not more than 1.5 µm. Thus, the semiconductor wafer according to the first aspect of the present invention has a relatively thin buffer layer and thus provides the basis for an easier production process and the production of thinner structures.

The multilayered structure may also comprise a second super lattice structure located between the first super lattice structure and the one or more monocrystalline, doped GaN layers. The second super lattice structure comprises periods, wherein each of the periods consists of a layer of AlₘGa₁₋ₘN and a layer of AlₙGa₁₋ₙN with m<x and n<y. The second super lattice structure has a lower average Al content compared to the super lattice structure as defined in claim 1.

In essence, the presence of island of AlₓGa₁₋ₓN and Al_{y}Ga_{1-y}N and a superlattice structure with continuous layers consisting of these materials allow the deposition of relatively thick monocrystalline, doped GaN layers which are free of cracks and have low dislocation density. At the same time, the total thickness of the layers located between the monocrystalline silicon substrate and the one or more monocrystalline, doped GaN layers is relatively low. This is due to the fact that the growth of both the superlattice structure and the islands is an effective way to bend and annihilate dislocations leading to a drastic reduction in dislocation density in a relatively thin set of layers. Thus, it is possible to avoid time-consuming conventional methods such as ELOG and thick buffer structures to achieve similar dislocation densities. In addition, sufficient compressive stress can be obtained by the deposition of the islands and the super lattice structure, so that the tensile stress during cooling can be compensated.

As the one or more monocrystalline, doped GaN layers deposited on top of the super lattice act as device layers, their composition, structure and stacking order depends on the application. The one or more monocrystalline, doped GaN layers have a thickness of not less than 6 µm, preferably of not less than 7 µm. The one or more monocrystalline, doped GaN layers preferably comprises a drain layer, a drift layer and a p-doped GaN layer in this order. In a preferred embodiment, the one or more monocrystalline, doped GaN layers preferably comprise an n-doped GaN layer as the drain layer, a further n-doped GaN layer as the drift layer and a p-doped GaN layer in this order. The n-dopant is preferably Si and the p-dopant is preferably Mg.

At least one of the one or more monocrystalline, doped GaN layers has a threading dislocation density of not more than 5.0×10⁸ cm⁻². The threading dislocation density can be determined by various methods. In the present invention, the threading dislocation density is preferably determined by means of transmission electron microscopy (TEM) or scanning electron microscopy (SEM) by recording an image in plan-view of the semiconductor wafer with the one or more monocrystalline, doped GaN layers and counting the dislocations on the recorded image.

In a more preferred embodiment, the drift layer has a thickness of not less than 3 µm, preferably not less than 4 µm and most preferably not less than 6 µm.

Generally, the one or more monocrystalline, doped GaN layers may contain a p-type dopant and/or an n-type dopant. The p-type dopant is preferably one or more element selected from the group consisting of Mg, Be, Zn and C. The n-type dopant is preferably one or more element selected from the group consisting of Si, Ge, Sn, O and C. The Si concentration in a Si-doped GaN layer is preferably not less than 1.0×10¹⁵ cm⁻³ and not more than 5.0×10¹⁹ cm⁻³, more preferably not less than 1.0×10¹⁵ cm⁻³ and not more than 1.0×10¹⁸ cm⁻³. If the Si-doped GaN layer is used as a drift layer, the Si concentration is preferably not less than 1.0×10¹⁵ cm⁻³ and not more than 5.0×10⁻⁶ cm⁻³.

The Mg concentration in a Mg-doped GaN layer is preferably not less than 1.0×10¹⁸ cm⁻³ and not more than 5.0×10²⁰ cm⁻³, more preferably not less than 1.0×10¹⁹ cm⁻³ and not more than 5.0×10²⁰ cm⁻³. For a PIN diode, the application of a further thin cap layer is advantageous. Such cap layer has a thickness of not less than 10 nm and not more than 50 nm, more preferably of not less than 10 nm and not more than 30 nm, and a dopant concentration of not less than 5.0×10¹⁹ cm⁻³ and not more than 5.0×10²⁰ cm⁻³. Most preferably, the cap layer has a dopant concentration of not less than 5.0×10¹⁹ cm⁻³ and not more than 1.0×10²⁰ cm⁻³, wherein the dopant is Mg.

The oxygen concentration in the one or more monocrystalline, doped GaN layers is preferably less than 1.0×10¹⁶ cm⁻³. The carbon concentration in the one or more monocrystalline, doped GaN layers is preferably less than 1.0×10¹⁸ cm⁻³, more preferably less than 5.0×10¹⁷ cm⁻³, and most preferably less than 5.0×10¹⁶ cm⁻³.

For example, the one or more mononcrystalline, doped GaN layers may comprise one or more Si-doped GaN layers and one or more Mg-doped GaN layers. The semiconductor wafer of claim 1 may also comprise one or more Sn-doped GaN layers.

For example, in one embodiment of the invention, the following layers may be deposited on the super lattice structure in this order:
A first Si-doped GaN layer, a second Si-doped GaN layer and a Mg-doped GaN layer, wherein the first Si-doped GaN layer has a higher Si concentration and a lower thickness compared to the second Si-doped GaN layer. Optionally, a further Mg-doped GaN layer can be deposited as cap layer. Such stack is suitable for the use as PIN-diode. The structure may also be used as a template for DMOSFETS.

In another embodiment of the invention, the following layers may be deposited on the super lattice structure in this order:
A first Si-doped GaN layer, a second Si-doped GaN layer, a Mg-doped GaN layer, a third Si-doped GaN layer and a fourth Si-doped GaN layer, wherein the second Si-doped GaN layer has a lower Si concentration and a higher thickness compared to the other Si-doped GaN layers. Such structure is suitable for a trench MOSFET structure.

In the second aspect of the present invention, a method of producing a semiconductor wafer having a multilayered structure is provided. The method comprises the following steps in this order:
(i) providing a monocrystalline silicon substrate having a {111} orientation;
(ii) flowing a gas stream which comprises an aluminum precursor and no nitrogen precursor over the substrate at a temperature of not less than 700 °C and not more than 900 °C so that the total amount of aluminum flown over the substrate is not less than 0.1 µmol and not more than 250 µmol,
(iii) depositing a low temperature AlN nucleation layer by flowing a gas stream comprising an aluminum precursor and a nitrogen precursor over the substrate at a temperature of not less than 700 °C and not more than 900 °C,
(iv) depositing a high temperature AlN nucleation layer by flowing a gas stream comprising an aluminum precursor and a nitrogen precursor over the substrate at a temperature of not less than 950 °C and not more than 1100 °C,
(v) depositing an Al_{z}Ga_{1-z}N layer with 0.3≤z≤0.7 by flowing a gas stream comprising an aluminum precursor, a gallium precursor and a nitrogen precursor over the substrate at a temperature of not less than 950 °C and not more than 1050 °C,
(vi) depositing alternately AlₓGa₁₋ₓN with 0.7≤x≤1.0 and Al_{y}Ga_{1-y}N with 0≤y≤0.5 for 20 to 100 cycles by flowing a gas stream comprising an aluminum precursor, a gallium precursor and a nitrogen precursor over the substrate at a temperature of not less than 1000°C and not more than 1100°C, wherein the alternation of the deposition is achieved by changing the composition of the gas stream; and
(vii) depositing one or more monocrystalline, doped GaN layers by flowing a gas stream comprising a gallium precursor, a nitrogen precursor and a dopant precursor over the substrate at a temperature of not less than 900 and not more than 1200°C.

In the method according to the second aspect of the present invention, various gas streams comprising precursor compounds are subsequently passed over the heated semiconductor wafer in a reactor with a reactor chamber. The reactor may be a horizontal laminar flow reactor, for example a commercially available planetary reactor from AIXTRON, or a vertical reactor, for example a commercially available vertical rotating disc reactor from Veeco Instruments.

Various precursors are used. An aluminum precursor within the meaning of the present invention is preferably an organoaluminium compound, more preferably a trialkyl aluminum compound, most preferably trimethyl aluminum or triethyl aluminum. A nitrogen precursor within the meaning of the present invention is preferably ammonia or a trialkyl ammonium compound, more preferably ammonia. An inert compound such as nitrogen is not considered as a nitrogen precursor within the meaning of the present invention. The Ga precursor is preferably a trialkyl gallium compound, more preferably trimethyl gallium or triethyl gallium. Preferably, in each of steps (ii) to (vii), a carrier gas comprising one or more selected from the group of helium, argon, nitrogen and hydrogen is used. The use of hydrogen and/or nitrogen as the carrier gas is particularly preferable. Most preferably, hydrogen is used as the carrier gas throughout steps (ii) to (vi).

The total pressure in steps (ii) to (vii) is preferably not less than 50 mbar and not more than 1000 mbar, more preferably not more than 500 mbar, even more preferably not more than 300 mbar and most preferably not more than 250 mbar. The total pressures in steps (ii) to (vii) refer to the total pressure inside the reaction chamber during the respective step.

The monocrystalline silicon substrate used in the method according to the second aspect of the invention is preferably a monocrystalline silicon substrate as described in connection with the first aspect of the present invention. Preferably, the monocrystalline silicon substrate is annealed at a temperature above 800°C, preferably above 1000°C, to remove surface oxides and contamination from the surface of the substrate.

In step (ii), a gas stream comprising an aluminum precursor and no nitrogen precursor is flown over the substrate at a temperature of not less than 700 °C and not more than 900 °C, so that the total amount of aluminum flown over the substrate is not less than 0.1 µmol and not more than 250 µmol.

The partial pressure of the aluminum precursor in the gas flow (i.e. the aluminum concentration therein), the volumetric flow rate and the duration of step (ii) is adjusted so that the total amount of aluminum flown over the substrate in this step is not less than 0.1 µmol and not more than 250 µmol, preferably not less than 1 and not more than 100 µmol. The total amount of aluminum flown over the substrate in step (ii) is calculated from the volumetric flow rate of the gas stream, the concentration or partial pressure of the aluminum precursor in the gas stream and the flow time, i.e. the time the gas stream is flown over the semiconductor wafer. Preferably, the time the gas stream is flown over the semiconductor wafer is not less than 2 and not more than 60 seconds, more preferably not less than 2 and not more than 20 seconds. This step is beneficial for preventing nitridation of the monocrystalline silicon substrate prior to the deposition of AlN.

In step (iii), a low temperature AlN nucleation layer is deposited by flowing a gas stream comprising an aluminum precursor and a nitrogen precursor over the substrate at a temperature of not less than 700 °C and not more than 900 °C, preferably not less than 750 °C and not more than 850 °C. The low temperature AlN nucleation layer is preferably a layer as defined in the first aspect of the present invention and has the purpose of providing nucleation sites for the growth of the high temperature AlN layer.

In step (iv), a high temperature AlN nucleation layer is deposited by flowing a gas stream comprising an aluminum precursor and a nitrogen precursor over the substrate at a temperature of not less than 950 °C and not more than 1100 °C, preferably not less than 1000 °C and not more than 1050 °C. The high temperature AlN nucleation layer is preferably a high temperature AlN nucleation layer as defined in the first aspect of the present invention.

In step (v), deposition of an Al_{z}Ga_{1-z}N layer with 0.3≤z≤0.7 occurs by flowing a gas stream comprising an aluminum precursor, a gallium precursor and a nitrogen precursor, and optionally a carrier gas such as hydrogen, over the substrate at a temperature of not less than 950 °C and not more than 1050 °C, preferably not less than 980 °C and not more than 1030 °C.

Under the above-mentioned conditions, V-pits are formed in the AIN layers. V-pits are voids having an inverse hexagonal pyramidal shape. The density and size of the V-pits depend on the conditions of AIN deposition. More particularly, the deposition of AlN layers under the conditions as defined in steps (iii) and (iv) results in a density of V-pits of not less than 5.0×10⁷ cm⁻² and not more than 5.0×10⁹cm⁻². The V-pits were found to be associated with screw dislocations in the AIN layer and serve as the source of island growth. The subsequently deposited Al_{z}Ga_{1-z}N layer is preferably deposited in the V-pits and the subsequent growth of islands occurs on such V-pits filled with Al_{z}Ga_{1-z}N. As a result, the island density is *inter alia* dependent on the growth conditions in steps (iii) to (v). As explained above, an island density in the above-mentioned range promotes the annihilation of dislocations and thus reduces the dislocation density in the one or more monocrystalline, doped GaN layers.

In step (vi), AlₓGa₁₋ₓN with 0.7≤x≤1.0 and Al_{y}Ga_{1-y}N with 0≤y≤0.5 is deposited alternately for 20 to 100 cycles by flowing a gas stream comprising an aluminum precursor, a gallium precursor and a nitrogen precursor, and optionally a carrier gas such as hydrogen, over the substrate at a temperature of not less than 1000°C and not more than 1100°C. The alternation of the deposition is achieved by changing the composition of the gas stream. Preferably, in step (vi), AlₓGa₁₋ₓN with 0.80≤x≤1.00 and Al_{y}Ga_{1-y}N with 0.05≤y≤0.40 is deposited. Most preferably, AlₓGa₁₋ₓN with 0.90≤x≤1.00 and Al_{y}Ga_{1-y}N with 0.10≤y≤0.20

In this step, islands and a super lattice structure is formed. During the first cycles of step (vi), preferably during at least 5 cycles, more preferably during the first 10 to 20 cycles, the vertical growth rate, i.e. the growth rate in a direction perpendicular to a plane of the monocrystalline silicon substrate with a {111} orientation, is much higher compared to the horizontal growth rate, i.e. the growth rate along a plane of the monocrystalline silicon substrate with a {111} orientation. This result in the formation of islands during the first cycles, preferably during at least 5 cycles, more preferably during 10 to 20 cycles. The dimensions, shape and density of the islands is controlled by the process conditions, in particular the temperature, pressure and the atomic ratio of group (v) to group (iii) elements in the gas phase, wherein only group (V) and group (III) elements from precursor compounds are taken into account. The process of island formation is also determined by the strain of the underlying layers. After the first cycles, preferably after not more than 20 cycles, the ratio of the vertical growth rate to the horizontal growth rate is decreased, so that the islands coalesce and continuous layers are deposited. During the transition from island growth to the deposition of continuous layers, new dislocations, in particular threading dislocations, can be generated at the coalescence boundaries. To further reduce the dislocation density, the superlattice is continued for at least 10 periods to prevent a high dislocation density and thus a fast relaxation of the initially compressive stressed GaN layer. Furthermore, the compressive stressed Al_{y}Ga_{1-y}N layer and tensile stressed AlₓGa₁₋ₓN layer collectively produce an effective lattice parameter, which can be altered by changing the Ga/AI ratio in the superlattice. This lattice parameter governs the amount of compressive stress in GaN.

Generally, in each of steps (ii) to (v), the gas stream satisfies an atomic ratio of group (V) elements resulting from the nitrogen precursor to group (III) elements resulting from the aluminum precursor and, if present, from the gallium precursor, of not less than 5 and not more than 100. As N₂ is not considered as a precursor within the meaning of the present invention, the nitrogen originating from N₂ in the carrier gas is not taken into account, when calculating the above ratio. Preferably, the gas streams in steps (ii) to (vi) contain one or more carrier gases selected from the group of hydrogen, nitrogen, helium and argon. More preferably, the gas stream in each of steps (ii) to (vi) contains hydrogen as the carrier gas. In one embodiment, the aluminum precursor is trimethylaluminum, the gallium precursor is trimethylgallium and the nitrogen precursor is ammonia. Generally, the chemical composition of the deposited layers depends on the atomic ratio of group (V) elements resulting from the nitrogen precursor to group (III) elements resulting from the aluminum precursor and, if present, from the gallium precursor. The growth mode also depends on this ratio.

Preferably, the alternation of the deposition in each cycle of step (vi) is achieved by changing the composition of the gas stream so that the atomic ratio of group (V) elements resulting from the nitrogen precursor to group (III) elements resulting from the aluminum precursor, and if present from the gallium precursor, in the gas stream is alternated between a first value of not more than 100 and a second value of not less than 200. In addition, the ratio of Al to Ga in the gas stream can be adjusted, in order to control the composition of the layers deposited in steps (v) and (vi). More preferably, the first value is not more than 50 and the second value is not less than 300. Most preferably, the first value is not less than 5 and not more than 50 and the second value is not less than 300 and not more than 500.

In one embodiment, the method is carried out in a reactor chamber having a total pressure of not less than 50 mbar and not more than 500 mbar throughout steps (ii) to (vii). The total pressure in the reaction chamber in step (iv) is preferably not less than 50 mbar and not more than 300 mbar.

The growth rate throughout steps (i) to (iv) is preferably in the range of 100 to 1500 nm/h. In steps (i) to (iii), the growth rate is more preferably in the range of 100 to 300 nm/h. Preferably, in step (vi), the growth rate of AlₓGa₁₋ₓN is in the range of 100 to 500 nm/h and the growth rate of Al_{y}Ga_{1-y}N is in the range of 700 to 1300 nm/h. The growth rate can be influenced by adjusting the temperature, the flow rate, the total pressure in the reaction chamber and the precursor concentration in the gas flow. In step (vii), the gas stream is preferably adjusted according to the desired composition of the doped GaN layer for each layer to be deposited.

If the one or more monocrystalline, doped GaN layers of the semiconductor wafer comprise a p-doped GaN layer, the wafer can be optionally in-situ annealed in a hydrogen-free atmosphere. Preferably, in-situ annealing occurs at a temperature of not less than 700 and not more than 900°C. In-situ annealing allows electrical activation of the p-doped GaN layer, in particular of Mg-doped GaN layers.

### Examples

A semiconductor wafer according to the first aspect of the present invention is produced in the following manner using the method of producing a semiconductor wafer according to the second aspect of the present invention:
A silicon substrate wafer (111) with a diameter of 150 mm and thickness of 750 µm is used as the substrate.

The nitride layers are deposited by metalorganic chemical vapour deposition (MOCVD) using trimethylgallium, trimethylaluminium, bis-methylcyclopentadienyl magnesium, silane and ammonia as precursors and hydrogen and nitrogen as carrier gases.

In Examples 1 to 5, the deposition of layers on the substrate by means of MOCVD was carried out in a commercially available vertical rotating disc reactor from Veeco Instruments. The pressure in steps (ii) to (vi) was about 100 mbar and the pressure in step (vii) was about 200 mbar.

The deposition is carried out with the following steps in this order: The substrate is heated and annealed at 1050 °C to remove the surface oxide and contaminations from the substrate surface. A gas stream comprising an aluminum precursor is flown over the substrate at a temperature of 800 °C, wherein the gas flow, the precursor concentration/partial pressure and the flow time are adjusted so that the total amount of aluminum flown over the substrate is about 10 µmol.

Then, the temperature is ramped down to 800 °C; a 1 nm thick low temperature AlN nucleation layer is deposited at 800 °C followed by growth interruption. The temperature is ramped up to 1050 °C and a 200 nm thick high temperature AlN nucleation layer is deposited at 1050 °C followed by growth interruption. The temperature is ramped down to 1010 °C and a 25 nm thick Al_{0.51}Ga_{0.49}N layer is deposited at 1010 °C followed by a growth interruption. Then, a sequence of deposition of 6 nm thick AIN and 26 nm thick Al_{0.12}Ga_{0.88}N is repeated 41 times at 1010 °C, followed by growth interruption. After that, a 800 nm thick GaN:Si layer with a silicon concentration of 5.0×10¹⁸ cm⁻³ is deposited as drain layer, followed by growth interruption. A 3.5 µm thick GaN:Si layer with a silicon concentration of 4.0×10¹⁶ cm⁻³ is deposited as the drift layer, followed by growth interruption. A 700 nm thick GaN:Mg layer with a magnesium concentration of 5.0×10¹⁹ cm⁻³ is deposited, followed by growth interruption and cooling to room temperature. The threading dislocation density was determined by means of transmission electron microscopy (TEM), in particular by means of plan view transmission electron microscopy. The TEM analysis revealed a threading dislocation density of 3.5×10⁸ cm⁻².

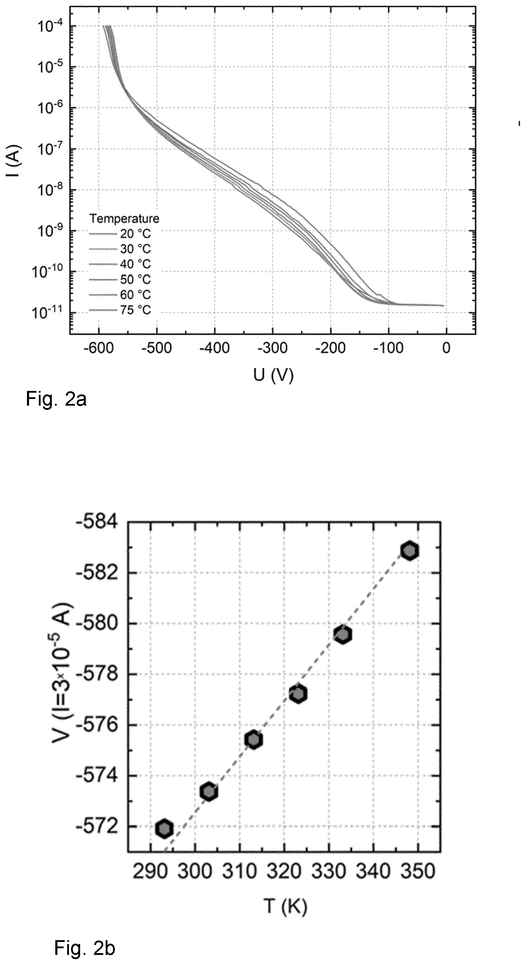

The material obtained in Example 1 is a PIN diode and was subsequently tested for its electrical properties by measuring the electrical current at different voltages. The reverse current-voltage curves obtained by these measurements are shown in Fig. 2a. Fig. 2b shows the temperature-dependent breakdown voltage of the PIN diode produced in Example 1. The curve shows an increase in breakdown voltage with temperature, which is characteristic of avalanche breakdown. This is evidence of good electrical properties of the material obtained in Example 1. In contrast, poor material quality would lead to early breakdown due to high leakage currents that could not support avalanche breakdown.

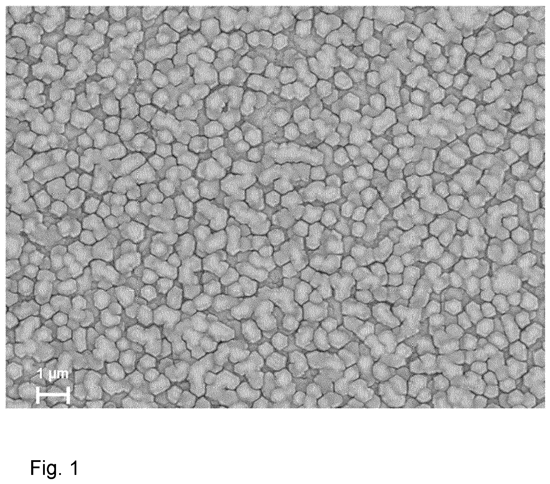

Example 2 was carried out under the same process conditions as Example 1, except that only 5 sequences/cycles of deposition of 6 nm thick AIN and 26 nm thick Al_{0.12}Ga_{0.88}N are carried out, before growth is interrupted and an image in a scanning electron microscope in plan view (SEM) is recorded. Fig. 1 shows the recorded SEM image. The total density of islands of AlₓGa₁₋ₓN and islands of Al_{y}Ga_{1-y}N is determined from the image to be less than 1.0×10⁹ cm⁻².

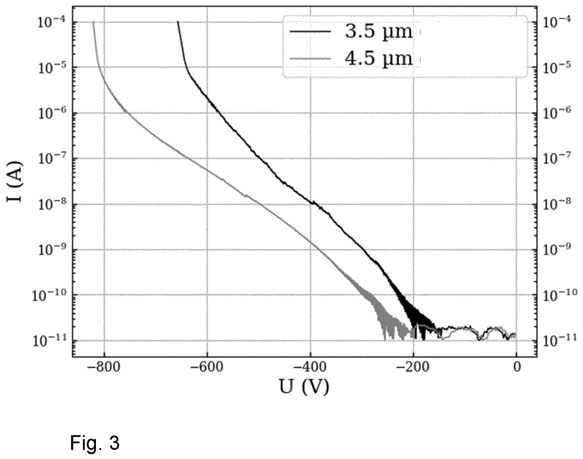

Examples 3 and 4 were carried out under the same conditions as Example 1, except that GaN drift layers with a thickness of 3 µm and 4.5 µm, respectively, were deposited, so that the total thickness of the set of GaN layers deposited on top of the buffer layer was 4.5 µm and 6 µm, respectively. After that, PIN diodes were prepared form these materials. The two PIN diodes obtained in Examples 3 and 4 were both tested for their electrical properties by measuring the reverse I-V curves at room temperature. These reverse I-V curves are shown in Fig. 3 and provide evidence of the good electrical properties of these materials.

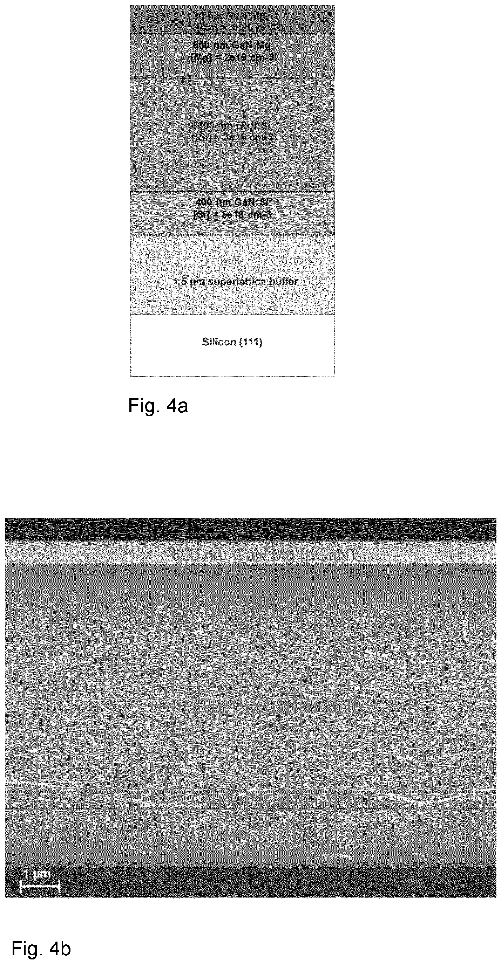

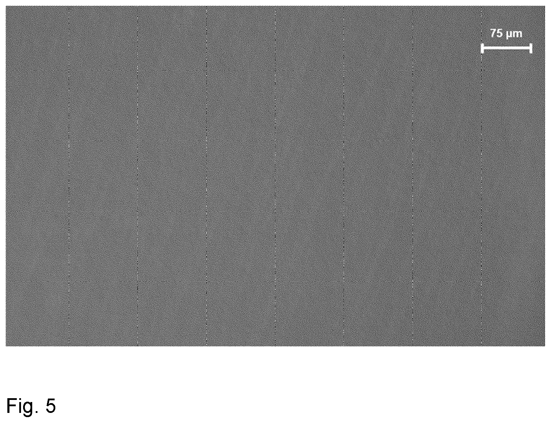

In Example 5, the same buffer layer as in Example 1 was prepared. After the preparation of the buffer layer, a 400 nm thick GaN:Si layer with a silicon concentration of 5.0×10¹⁸ cm⁻³ is deposited on top of the super lattice structure as drain layer, followed by growth interruption. A 6 µm thick GaN:Si layer with a silicon concentration of 4.0×10¹⁶ cm⁻³ is deposited as the drift layer, followed by growth interruption. A 600 nm thick GaN:Mg layer with a magnesium concentration of 2.0×10¹⁹ cm⁻³ is deposited, followed by growth interruption. Finally, a Mg cap layer having a thickness of 30 nm and a magnesium concentration of 1.0×10²⁰ cm⁻³ is deposited, followed by growth interruption. Before cooling to room temperature, the sample can be annealed at 800°C in nitrogen atmosphere. Fig. 4a shows a schematic drawing and Fig. 4 b shows an SEM image of the semiconductor wafer obtained in Example 5. Fig. 5 shows an image of the wafer obtained in Example 5 recorded on an optical microscope. Fig. 5 demonstrates that the present invention enables the deposition a crack-free set of GaN layers with a total thickness of 7 µm, including a crack-free drift layer having a thickness of 6 µm.

## Claims

1. A semiconductor wafer having a multilayered structure and a diameter of not less than 150 mm and not more than 300 mm, wherein the multilayered structure comprises in this order
a monocrystalline silicon substrate having a {111} orientation;
a low temperature AIN nucleation layer;
a high temperature AIN nucleation layer;
an Al_{z}Ga_{1-z}N layer;
islands of AlₓGa₁₋ₓN and islands of Al_{y}Ga_{1-y}N;
a superlattice structure comprising 20 to 60 periods, each period consisting of a layer of AlₓGa₁₋ₓN and a layer of Al_{y}Ga_{1-y}N; and
one or more monocrystalline, doped GaN layers having a total thickness of not less than 6 µm,
wherein at least one of the one or more monocrystalline, doped GaN layers has a threading dislocation density of not more than 5.0×10⁸ cm⁻², and
wherein 0.3≤z≤0.7; 0.7≤x≤1.0; and 0≤y≤0.5.

2. The semiconductor wafer according to claim 1, wherein 0.80≤x≤1.00 and 0.05≤y≤0.40.

3. The semiconductor wafer according to claim 1 or 2, wherein each period of the superlattice structure has a thickness of not less than 18 nm and not more 50 nm.

4. The semiconductor wafer according to any one of claims 1 to 3, wherein the average Al content of the superlattice structure is less than 50 wt.%.

5. The semiconductor wafer according to any one of claims 1 to 4, wherein the total density of islands of AlₓGa₁₋ₓN and islands of Al_{y}Ga_{1-y}N is not less than 5.0×10⁷ cm⁻² and not more than 5.0×10⁹ cm⁻².

6. The semiconductor wafer according to any one of claims 1 to 5, wherein the islands have an aspect ratio of not less than 0.1 and not more than 10.

7. The semiconductor wafer according to any one of claims 1 to 6, wherein the height of the islands is not less than 100 nm and not more than 1000 nm.

8. The semiconductor wafer according to any one of claims 1 to 7, wherein the total thickness of the layers located between the monocrystalline silicon substrate and the one or more monocrystalline, doped GaN layers is not less than 0.7 µm and not more than 1.5 µm.

9. The semiconductor wafer according to any one of claims 1 to 8, wherein the thickness of the low temperature AlN nucleation layer is not less than 1 nm and not more than 5 nm and the thickness of the high temperature AlN nucleation layer is not less than 50 and not more than 500 nm.

10. The semiconductor wafer according to any one of claims 1 to 9, wherein the multilayered structure comprises a second super lattice structure located between the first super lattice structure and the one or more monocrystalline, doped GaN layers and the second super lattice structure has a lower average Al content than the superlattice structure as defined in claim 1.

11. Method of producing a semiconductor wafer having a multilayered structure comprising the following steps in this order
(i) providing a monocrystalline silicon substrate having a {111} orientation;
(ii) flowing a gas stream which comprises an aluminum precursor and no nitrogen precursor over the substrate at a temperature of not less than 700 °C and not more than 900 °C so that the total amount of aluminum flown over the substrate is not less than 0.1 µmol and not more than 250 µmol,
(iii) depositing a low temperature AlN nucleation layer by flowing a gas stream comprising an aluminum precursor and a nitrogen precursor over the substrate at a temperature of not less than 700 °C and not more than 900 °C,
(iv) depositing a high temperature AlN nucleation layer by flowing a gas stream comprising an aluminum precursor and a nitrogen precursor over the substrate at a temperature of not less than 950 °C and not more than 1100 °C,
(v) depositing an Al_{z}Ga_{1-z}N layer with 0.3≤z≤0.7 by flowing a gas stream comprising an aluminum precursor, a gallium precursor and a nitrogen precursor over the substrate at a temperature of not less than 950 °C and not more than 1050 °C,
(vi) depositing alternately AlₓGa₁₋ₓN with 0.7≤x≤1.0 and Al_{y}Ga_{1-y}N with 0≤y≤0.5 for 20 to 100 cycles by flowing a gas stream comprising an aluminum precursor, a gallium precursor and a nitrogen precursor over the substrate at a temperature of not less than 1000°C and not more than 1100°C, wherein the alternation of the deposition is achieved by changing the composition of the gas stream; and
(vii) depositing one or more monocrystalline, doped GaN layers by flowing a gas stream comprising a gallium precursor, a nitrogen precursor and a dopant precursor over the substrate at a temperature of not less than 900°C and not more than 1200°C.

12. The method of producing a semiconductor wafer having a multilayered structure according to claim 11, wherein, in each of steps (ii) to (iv), the gas stream satisfies an atomic ratio of group (V) elements resulting from the nitrogen precursor to group (III) elements resulting from the aluminum precursor of not less than 5 and not more than 100.

13. The method of producing a semiconductor wafer having a multilayered structure according to claim 11 or 12, wherein the alternation of the deposition in each cycle of step (vi) is achieved by changing the composition of the gas stream so that the atomic ratio of group (V) elements resulting from the nitrogen precursor to group (III) elements resulting from the aluminum precursor and, if applicable, the gallium precursor, in the gas stream is alternated between a first value of not more than 100 and a second value of not less than 200.

14. The method of producing a semiconductor wafer having a multilayered structure according to any one of claims 11 to 13, wherein the method is carried out in a reactor chamber having a total pressure of not less than of 50 and not more than 300 mbar throughout steps (ii) to (vii).

15. The method of producing a semiconductor wafer having a multilayered structure according to any one of claims 11 to 14, wherein in step (vi) the growth rate of AlₓGa₁₋ₓN is in the range of 100 to 500 nm/h and the growth rate of Al_{y}Ga_{1-y}N is in the range of 700 to 1300 nm/h.
